# FASCICULE DE BREVET EUROPEEN

(11) **EP 2 668 480 B1**
(45) Date de publication et mention de la délivrance du brevet: **07.01.2015**
(21) Numéro de dépôt: 12705366.8
(22) Date de dépôt: 24.01.2012
(51) Int. Cl.: G01R 3/00, G01L 1/18, D04B 1/14

(54) **DISPOSITIF DE MESURE DE LA PRESSION A PARTIR D'UN OBJET SOUPLE, PLIABLE ET/OU EXTENSIBLE REALISE A PARTIR DE MATIERE TEXTILE COMPORTANT UN DISPOSITIF DE MESURE**
VORRICHTUNG ZUR MESSUNG DES DRUCKS IN EINEM FLEXIBLEN, FALTBAREN UND/ODER AUSFAHRBAREN OBJEKT AUS EINEM TEXTILMATERIAL MIT EINER SOLCHEN MESSVORRICHTUNG
DEVICE INTENDED FOR MEASURING PRESSURE FROM A FLEXIBLE, FOLDABLE, AND/OR EXTENDABLE OBJECT MADE OF A TEXTILE MATERIAL AND COMPRISING A MEASUREMENT DEVICE

(30) Priorité: 25.01.2011 FR 1150589
(43) Date de publication de la demande: 04.12.2013
(73) Titulaire: Cannard, Francis, 21200 Beaune (FR)
(72) Inventeur: VUILLERME, Nicolas, F-73800 Francin (FR); PAYAN, Yohan, F-38580 Allevard (FR); DIOT, Bruno, F-71640 Mercurey (FR)
(74) Mandataire: Cabinet Laurent & Charras
(86) Numéro de dépôt international: PCT/FR2012/050151
(87) Numéro de publication internationale: WO 2012/101374

(56) Documents cités:
- US-A- 6 155 120
- US-A1- 2003 119 391
- HUANG C T ET AL: "Parametric design of yarn-based piezoresistive sensors for smart textiles", SENSORS AND ACTUATORS A, ELSEVIER SEQUOIA S.A., LAUSANNE, CH, vol. 148, no. 1, 4 novembre 2008 (2008-11-04), pages 10-15, XP025535256, ISSN: 0924-4247, DOI: 10.1016/J.SNA.2008.06.029 [extrait le 2008-07-05]

## Description

### DOMAINE DE L'INVENTION

La présente invention concerne un dispositif de mesure de la pression à partir d'un objet souple ou pliable tel qu'un tissu par exemple, particulièrement adapté pour la mesure de pression afin de prévenir l'apparition de plaies de pression chez des personnes atteintes de maladies chroniques, d'une perte de mobilité ou de sensibilité par exemple.

### ARRIERE PLAN DE L'INVENTION

Il est bien connu que mesurer la pression, et de manière plus générale la distribution de forces sur une surface déterminée, peut être obtenue au moyen de capteurs de pression dits capacitifs. Lesdits capteurs de pression capacitifs comportent une ou plusieurs cellules capacitives qui sont positionnées de manière appropriée sur la surface de contact du capteur. Chaque cellule capacitive comprend une paire de panneaux obtenus dans un matériau électriquement conducteur et une couche d'un matériau isolant ou diélectrique positionnée entre les panneaux conducteurs.

La mesure de la pression agissant sur les cellules capacitives du capteur est obtenue en mesurant la variation de la capacitance des cellules capacitives produite par la variation de la distance entre les panneaux conducteurs sur lesquels une pression est exercée.

C'est le cas notamment de la demande de brevet européen EP 1211633 qui décrit un dispositif de mesure de la distribution de pression sur une surface.

On connaît également des dispositifs de mesure de la pression comportant des capteurs de pression dits résistifs.

C'est le cas notamment du brevet américain US 6,155,120 qui décrit un procédé et un appareil de mesure de la pression d'un pied au moyen de la variation de la piézo-résistance. Ledit appareil comporte une matrice rectangulaire de capteurs de force piézo-résistifs enfermés à l'intérieur d'une fine enveloppe polymère que l'on introduit à l'intérieur d'une chaussure, ou que l'on incorpore à une chaussette susceptible d'habiller un pied ou un sabot. La réalisation préférée de l'invention utilise des éléments piézo-résistifs de détection de pressions ou de forces normales, qui comportent un réseau polymère tissé imprégné de particules conductrices en suspension à l'intérieur d'un véhicule élastomère, de préférence du caoutchouc silicone. La couche piézo-résistive maillée est prise en sandwich entre une matrice de structures lamifiées constituées de bandes conductrices organisées en colonnes et en rangées, de préférence constituée d'un réseau en Nylon(R) imprégné de trajets métalliques imprimés. Dans une variation de la réalisation de base, chaque élément de détection des forces normales est bordé de paires d'éléments de détection des forces de cisaillement, disposées latéralement et longitudinalement, chacun des éléments de détection des forces de cisaillement comportant une paire de tampons piézo-résistifs élastiques adjacents qui possèdent des surfaces latérales longitudinalement en contact. Ces tampons peuvent se déplacer par glissement, et lorsqu'ils sont forcés à un contact plus ou moins rapproché en réponse à des forces de cisaillement dirigées perpendiculairement à leur plan de contact tangent, la résistance électrique entre les tampons varie de manière préétablie en fonction des forces de cisaillement.

On connaît également la demande de brevet américain US 2009/0128168 qui décrit des structures polymère conductrice multifonctionnelles et plus particulièrement l'utilisation de polymères conducteurs comme capteurs dans des systèmes de détection distribués, comme capteurs et éléments d'actionnement dans des dispositifs multifonctionnels, et pour des tissus multifonctionnels comprenant de tels polymères conducteurs pour contrôler l'humidité, la respiration, le rythme cardiaque, la pression sanguine, la température de la peau, le poids et les mouvements, dans un système de capteurs intégrés dans des vêtements, par exemple. Un tissu comprenant des fibres conductrices de polyaniline qui peuvent être utilisées aussi bien pour distribuer l'énergie dans un chauffage résistif que pour mesurer la température du tissu est décrit comme exemple d'un capteur multifonctionnel en tissu. Dans une variante d'exécution, il est décrit un tissu comportant des fibres de polyaniline pour la réalisation d'un capteur de pression, la pression étant déduite directement de la variation de la résistance des fibres de polyaniline.

Tous ces dispositifs comportant des capteurs capacitifs ou résistifs présentent l'inconvénient de présenter une faible souplesse limitant considérablement leur champ d'application, ces dispositifs procurant un confort insuffisant pour être utilisés dans des vêtements par exemple. Par ailleurs, ces dispositifs présentent des coûts de fabrication élevés, dus à l'utilisation de moyens de production spécifiques, incompatibles avec une diffusion de grande série et la pression mesurée par les capteurs capacitifs dépend des phénomènes ambiants tels que la température et/ou humidité.

### BREVE DESCRIPTION DE L'INVENTION

L'un des buts de l'invention est donc de remédier à ces inconvénients en proposant un dispositif de mesure de la distribution de la pression sur une surface souple ou pliable telle qu'un tissu par exemple, de conception simple, peu onéreuse et procurant une mesure de la pression indépendante des phénomènes ambiants tels que la température et/ou humidité régnant à la surface du tissu.

A cet effet et conformément à l'invention, il est proposé un dispositif de mesure de la pression et/ou de la traction exercée en différents points d'une matière textile souple, pliable et/ou extensible, apte à être utilisée comme vêtement, parement ou similaire ; ledit dispositif est remarquable en ce qu'il comporte d'une part au moins un capteur obtenu à partir d'une seule couche constituée par un arrangement d'au moins trois types de fibres, des fibres piézo-résistives formant des zones piézo-résistives, des fibres conductrices formant des zones électriquement conductrices, et des fibres isolantes formant des zones électriquement isolantes, et d'autre part un circuit électronique apte à mesurer la variation de la résistance électrique des zones piézo-résistives soumises à une ou plusieurs forces.

Ladite couche est constituée d'au moins une zone piézo-résistive et d'au moins deux zones conductrices isolées l'une de l'autre par des zones isolantes en contact par paires avec la zone piézo-résistive, chacune desdites zones pouvant être constituées d'une ou plusieurs rangées de fibres.

De préférence, le dispositif suivant l'invention est constitué de plusieurs zones piézo-résistives, une zone conductrice commune connectant une grappe de zones piézo-résistives afin de diminuer le nombre de paires de zones conductrices.

Avantageusement, la couche constituée par les zones isolantes, piézo-résistives et conductrices est obtenue à partir de fibres textiles tricotés, tissés, non-tissés ou tressés.

Par ailleurs, le matériau piézo-résistif consiste dans un polymère conducteur intrinsèque (PCI) et/ou un métal organique, et de préférence dans de la polyaniline et/ou dans du polypyrrole, et/ou dans des nanotubes de carbone.

De plus, les fils conducteurs consistent dans des fils d'argent et/ou de nickel.

Les rangées de fibres conductrices, de fibres isolantes et de fibres piézo-résistives sont obtenues à partir des rangées du sens trame ou des rangées du sens chaîne du tissu, les zones pouvant être constituées d'une ou de plusieurs rangées de fibres.

Ledit circuit électronique comporte des moyens de mesure d'une variation de résistance électrique à partir du balayage de la grappe des capteurs, le balayage étant obtenu à partir de la sélection séquentielle d'une des électrodes composant la paire de zones conductrices, la lecture de la variation de résistance du capteur étant obtenue à partir d'un convertisseur analogique-numérique.

Accessoirement, le circuit électronique contient un processeur assurant l'analyse des pressions et incluant des méthodes permettant le traitement des applications, et des moyens permettant d'envoyer les données mesurées à partir des capteurs et le résultat des traitements.

Un autre objet de l'invention concerne un capteur pour la mesure d'une pression et/ou d'une traction apte à être connecté à un circuit électronique mesurant la variation de la résistance électrique lorsqu'une pression et/ou une traction est exercée sur ledit capteur, la pression et/ou la traction étant une fonction de la variation de la résistance ; ledit capteur est remarquable en ce qu'il est constituée par un arrangement d'au moins trois types de fibres ne formant qu'une seule couche, des fibres piézo-résistives formant des zones piézo-résistives, des fibres conductrices formant des zones électriquement conductrices, et des fibres isolantes formant des zones électriquement isolantes, et d'autre part un circuit électronique apte à mesurer la variation de la résistance électrique des zones piézo-résistives soumises à une ou plusieurs forces.

Ladite couche est constituée d'au moins une zone piézo-résistive et d'au moins deux zones conductrices isolées l'une de l'autre par des zones isolantes en contact par paires avec la zone piézo-résistive, chacune desdites zones pouvant être constituées d'une ou plusieurs rangées de fibres.

De préférence, le capteur est constitué de plusieurs zones piézo-résistives, une zone conductrice commune connectant une grappe de zones piézo-résistives afin de diminuer le nombre de paires de zones conductrices.

Par ailleurs, le matériau piézo-résistif consiste dans un polymère conducteur intrinsèque (PCI) et/ou un métal organique et de préférence dans de la polyaniline et/ou du polypyrrole, et/ou dans des nanotubes de carbone.

De plus, les fils conducteurs consistent dans des fils d'argent et/ou de nickel.

Un dernier objet de l'invention concerne un procédé de fabrication d'au moins un capteur pour la mesure d'une pression et/ou d'une traction apte à être connecté à un circuit électronique mesurant la variation de la résistance électrique lorsqu'une pression et/ou une traction est exercée sur ledit capteur, la pression et/ou la traction étant une fonction de la variation de la résistance ; ledit procédé est remarquable en ce qu'il consiste à réaliser sur une seule couche un arrangement par tissage, tricotage ou tressage d'au moins trois types de fibres, des fibres piézo-résistifs, des fibres conductrices et des fibres isolantes, afin de former une couche textile comportant au moins une zone piézo-résistive, au moins deux zones électriquement conductrices, et au moins une zone électriquement isolante.

On observera que c'est la structure textile qui forme le capteur. Etant donné qu'il n'y a pas d'intégration d'un capteur externe contrairement à la plupart des dispositifs de l'art antérieur, la structure textile ne possède pas de surépaisseur. Ainsi, il est possible d'utiliser cette technique pour fabriquer par exemple des chaussettes aptes à mesurer des pressions sans gêne pour l'utilisateur et pouvant être portées en permanence.

De plus, comme la structure textile peut être fabriquée par les moyens traditionnels de l'industrie textile, le coût de fabrication est très bas. Il est possible de la sorte de fabriquer des chaussettes sur des métiers chaussants traditionnels.

Enfin, de par la structure textile du dispositif, ce dernier est avantageusement perméable à l'air.

### BREVE DESCRIPTION DES DESSINS

- la figure 1 est une représentation schématique en perspective du dispositif de mesure de la pression conforme à l'invention,
- la figure 2 est une représentation schématique de dessus du dispositif de mesure de la pression suivant l'invention,
- la figure 3 est une représentation schématique du circuit électronique du dispositif de mesure de la pression conforme à l'invention,
- la figure 4 est une vue de dessus partielle du dispositif de mesure conforme à l'invention obtenue dans une maille cueillie, c'est-à-dire une maille tricotée dans le sens trame,
- la figure 5 est une vue en perspective partielle du dispositif de mesure conforme à l'invention obtenue dans une maille cueillie, c'est-à-dire une maille tricotée dans le sens trame, représentée sur la figure 4.

### DESCRIPTION DETAILLEE DE L'INVENTION

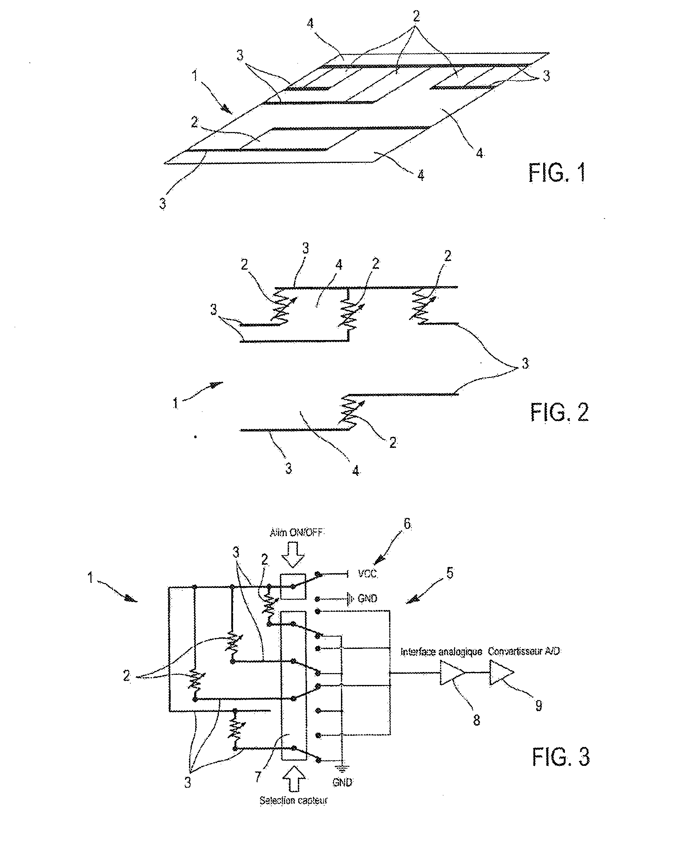

En référence aux figures 1 à 3, le dispositif de mesure de la pression et/ou de la traction exercée sur une surface suivant l'invention est constitué d'une seule couche 1 constituée par un arrangement d'au moins trois types de fibres, des fibres piézo-résistives formant des zones piézo-résistives 2, des fibres conductrices formant des zones électriquement conductrices 3, et des fibres isolantes formant des zones électriquement isolantes 4.

Dans cet exemple particulier de réalisation, le dispositif est constitué de plusieurs zones piézo-résistives 2, une zone conductrice 3 commune connectant une grappe de zones piézo-résistives 2, chaque zone piézo-résistive formant un capteur, afin de diminuer le nombre de paires de zones conductrices.

Il va de soi que la couche 1 peut être constituée d'un nombre quelconque de zones piézo-résistives disposées de manière quelconque sur la couche 1, le nombre et la position desdites zones piézo-résistives dépendant de l'application envisagée, et de manière générale, la couche 1 est constituée d'au moins une zone piézo-résistive 2 et d'au moins deux zones conductrices 3 isolées l'une de l'autre par des zones isolantes 4 et en contact par paires avec la zone piézo-résistive 2, chacune desdites zones 2,3,4 pouvant être constituées d'une ou plusieurs rangées de fibres.

De manière avantageuse, la couche 1 constituée par les zones isolantes 4, piézo-résistives 2 et conductrices 3 est obtenue à partir de fibres textiles tricotés, tissés, non-tissés ou tressés.

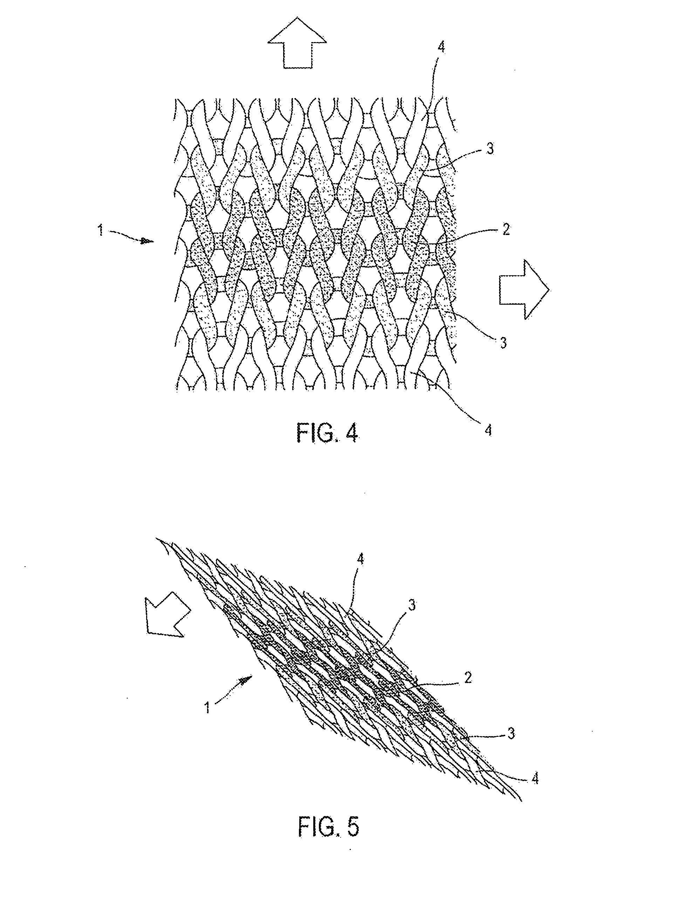

En référence aux figures 4 et 5, la couche 1 est constituée par des zones piézo-résistives 2, conductrices 3 et isolantes 4 obtenue par tricotage à maille cueillie, c'est-à-dire une maille tricotée dans le sens trame, de fibres obtenues dans un matériau piézo-résistif, de fibres obtenues dans un matériau conducteur et respectivement de fibres obtenues dans un matériau isolant. Par exemple, le matériau piézo-résistif consiste dans un polymère conducteur intrinsèque (PCI) et/ou un métal organique, et de préférence dans de la polyaniline et/ou du polypyrrole, et/ou dans des nanotubes de carbone. Par ailleurs, les fils conducteurs consistent dans des fils d'argent et/ou des fils de nickel. De plus, les fibres isolantes consistent dans des fibres de coton, de nylon ou toute autre fibre ou matériau présentant des caractéristiques d'isolant électrique, ou un mélange de telles fibres.

On observera que la déformation des fibres piézo-résistives lorsque qu'une traction est exercée sur la couche (figure 4) ou lorsqu'une pression est exercée sur ladite couche 1 (figure 5) procure une variation de la résistance électrique qui peut être mesurée pour déterminer la traction et/ou la pression exercée sur la couche 1 comme il sera détaillé plus loin.

Les rangées de fibres conductrices, de fibres isolantes et de fibres piézo-résistives sont obtenues à partir des rangées du sens trame ou des rangées du sens chaîne du tricot ou du tissu, les zones pouvant être constituées d'une ou de plusieurs rangées de fibres.

Il est bien évident que les différentes zones 2,3 et 4 peuvent être obtenues par tout type de tricotage tel qu'un tricotage à maille jetée, c'est-à-dire une maille tricotée dans le sens chaine, ou à maille cueillie par tout type de tissage ou de tressage sans sortir du cadre de l'invention.

Par ailleurs, en référence à la figure 3, le dispositif suivant l'invention comporte un circuit électronique 5 apte à mesurer la variation de la résistance électrique des zones piézo-résistives soumises à une ou plusieurs forces. Ledit circuit électronique 5 comporte des moyens de mesure d'une variation de résistance électrique à partir du balayage de la grappe des capteurs, i.e. des zones piézo-résistives 2, le balayage étant obtenu à partir de la sélection séquentielle d'une des électrodes, i.e. d'une des zones conductrices 3, composant la paire de zones conductrices 3, la lecture de la variation de résistance du capteur étant obtenue à partir d'un convertisseur analogique-numérique.

Ainsi, des fils conducteurs des zones conductrices 3 en contact avec une zone piézo-résistive 2 sont connectés à une source d'alimentation 6 et les autres fils conducteurs 5 sont connectés à un bus 7 collectant sélectivement les charges créées par le matériau piézo-résistif dans les zones piézo-résistives 2 lorsqu'une pression et/ou une traction est exercée sur au moins l'une de ces zones. Ledit bus 7 est connecté à une interface analogique 8 connecté à un convertisseur A/D (Analogique/Digital) 9 pour permettre une exploitation des données mesurées.

Accessoirement, le circuit électronique 5 contient un processeur, tel que le processeur d'un ordinateur de type PC ou similaire, non représenté sur les figures, assurant l'analyse des pressions et incluant des méthodes permettant le traitement des applications, et des moyens permettant d'envoyer les données mesurées à partir des capteurs et le résultat des traitements. Lesdits moyens de transmission des données peuvent consister dans tous moyens de transmission filaire ou sans fil tel que des moyens de transmissions wi-fi, bluetooth, RFID ou similaire, bien connu de l'homme du métier. Du fait de la simplicité du montage électronique, le système peut être embarqué et fonctionner à partir d'une source d'alimentation électrique telle qu'une batterie ou une pile de petite taille de type pile au lithium par exemple.

Selon une variante d'exécution, en référence aux figures 1 à 3, le dispositif suivant l'invention est constitué d'au moins une zone de tissu 2 enduit d'un matériau piézo-résistif, de fils conducteurs 3 en contact avec ladite zone 1 et un circuit électronique 5 apte à mesurer la charge électrique crée dans ladite zone 2 par effet piézo-résistif lorsqu'une pression est exercée sur ladite zone 2, la pression étant proportionnelle à la charge électrique mesurée.

Dans la suite de la description, on entend par tissu une surface souple et résistante constituée par un assemblage régulier de fils textiles entrelacés soit tissés soit maillés ou par un film synthétique ou un assemblage de films synthétiques. Par ailleurs, on entend par matériau piézo-résistif un matériau apte à procurer une variation de résistance dudit matériau lorsque le matériau est soumis à une contrainte mécanique telle qu'une pression par exemple.

Dans cet exemple particulier de réalisation, le dispositif suivant l'invention est constitué d'un tissu isolant 1, obtenu dans du coton, du nylon ou tout autre fibre ou matériau présentant des caractéristiques d'isolant électrique, ou un mélange de telles fibres, formant un support isolant et sur lequel un matériau piézo-résistif, de préférence un polymère conducteur intrinsèque (PCI) et/ou un métal organique tel que de la polyaniline (PANI) commercialisé par la société ORMECON™ par exemple et/ou du polypyrrole (PPY), par exemple, et/ou dans des nanotubes de carbone, est déposée dans plusieurs zones 2 de la face supérieure du tissu 4. Ces zones 2 présentent une forme géométrique quelconque tel qu'une forme rectangulaire, carré, ronde, etc... Le nombre et la position de ces zones 2 sur la face supérieure du tissu isolant 1 dépendra notamment de l'application envisagée. On observera que ces zones 2 peuvent également être positionnées indifféremment sur la face supérieure et/ou inférieure du tissu isolant.

Il est bien évident que le matériau piézo-résistif pourra consister dans tout matériau piézo-résistif bien connu de l'homme sans pour autant sortir du cadre de l'invention.

Le matériau piézo-résistif est de préférence déposé dans les zones 2 par un procédé d'enduction bien connu de l'homme métier ; toutefois, le matériau piézo-résistif pourra être déposé dans lesdites zones 2 par tout autre moyen approprié tel que par projection par exemple sans sortir du cadre de l'invention.

Alternativement, le matériau piézo-résistif peut consister dans un tissu piézo-résistif apte à être solidarisé sur le tissu isolant 1 par tout moyen approprié tel que par collage, piqure ou similaire.

Par ailleurs, le dispositif suivant l'invention comporte des fils conducteurs 3 connectés par paires à chacune desdites zones 2 enduites. Ces fils conducteurs 3 consistent par exemple dans des fils d'argent en contact avec deux cotés opposée de chaque zone enduite 2. Ces fils conducteurs 3 peuvent être mis en contact avec les zones 2 par tout moyen appropriés tel que par tissage dans la trame du tissu, par couture dans le tissu, par collage, etc...bien connu de l'homme du métier.

En référence à la figure 3, un des fils conducteurs 3 en contact avec une zone enduite 2 est connecté à une source d'alimentation 6 et les autres fils conducteurs 3 sont connectés à un bus 7 collectant sélectivement les charges créées par le matériau piézo-résistif dans les zones enduites 1 lorsqu'une pression est exercée sur au moins l'une de ces zones. Ledit bus est connecté à une interface analogique 8 connecté à un convertisseur A/D (Analogique/Digital) 9 pour permettre une exploitation des données mesurées.

On notera que le dispositif suivant l'invention trouvera un grand nombre d'applications pour des capteurs capables de se conformer à différentes formes. Leur souplesse et leur confort permettent une utilisation privilégiée dans la mesure des pressions autour du corps humain. Ils peuvent par exemple être utilisés pour mesurer des pressions excessives qui pourraient entraîner l'apparition de plaies de pression, particulièrement sur des surfaces molles telle que des coussins ou des lits d'hôpitaux ; mais aussi entre le corps et un corset pour les scolioses. Etant donné que ces textiles sensibles s'intègrent facilement aux vêtements, ils peuvent équiper un sous-vêtement ou un vêtement tel que des chaussettes, par exemple, sensibles à la pression qui analysent aussi bien les pressions plantaires que celles exercées autour du pied.

## Revendications

1. Dispositif de mesure de la pression et/ou de la traction exercée en différents points d'une matière textile souple, pliable et/ou extensible, apte à être utilisée comme vêtement, parement ou similaire **caractérisé en ce qu'**il comporte d'une part au moins un capteur obtenu à partir d'une seule couche (1) constituée par un arrangement d'au moins trois types de fibres, des fibres piézo-résistives formant des zones piézo-résistives (2), des fibres conductrices formant des zones électriquement conductrices (3), et des fibres isolantes formant des zones électriquement isolantes (4), et d'autre part un circuit électronique (5) apte à mesurer la variation de la résistance électrique des zones piézo-résistives (2) soumises à une ou plusieurs forces.

2. Dispositif suivant la revendication 1 **caractérisé en ce que** la couche (1) est constituée d'au moins une zone piézo-résistive (2) et d'au moins deux zones conductrices (3) isolées l'une de l'autre par des zones isolantes (4) et en contact par paires avec la zone piézo-résistive (2), chacune desdites zones (2,3,4) pouvant être constituées d'une ou plusieurs rangées de fibres.

3. Dispositif suivant l'une quelconque des revendications 1 ou 2 **caractérisé en ce que** la couche (1) est constituée de plusieurs zones piézo-résistives (2), une zone conductrice (3) commune connectant une grappe de zones piézo-résistives (2) afin de diminuer le nombre de paires de zones conductrices (3).

4. Dispositif suivant l'une quelconque des revendications 1 à 3 **caractérisé en ce que** la couche (1) constituée par les zones isolantes (4), piézo-résistives (2) et conductrices (3) est obtenue à partir de fibres textiles tricotés, tissés, non-tissés ou tressés.

5. Dispositif suivant l'une quelconque des revendications 1 à 4 **caractérisé en ce que** le matériau piézo-résistif consiste dans un polymère conducteur intrinsèque (PCI) et/ou un métal organique et/ou dans des nanotubes de carbone et/ou de la polyaniline et/ou du polypyrrole.

6. Dispositif suivant l'une quelconque des revendications 1 à 5 **caractérisé en ce que** les fils conducteurs consistent dans des fils d'argent et/ou des fils de nickel.

7. Dispositif suivant l'une quelconque des revendications 1 à 6 **caractérisé en ce que** les rangées de fibres conductrices, de fibres isolantes et de fibres piézo-résistives sont obtenues à partir des rangées du sens trame ou des rangées du sens chaîne du tissu, les zones (2,3,4) pouvant être constituées d'une ou de plusieurs rangées de fibres.

8. Dispositif suivant l'une quelconque des revendications 1 à 7 **caractérisé en ce que** le circuit électronique (5) comporte des moyens de mesure d'une variation de résistance électrique à partir du balayage de la grappe des capteurs, le balayage étant obtenu à partir de la sélection séquentielle d'une des électrodes composant la paire de zones conductrices, la lecture de la variation de résistance du capteur étant obtenue à partir d'un convertisseur analogique-numérique (9).

9. Dispositif suivant la revendication 8 **caractérisé en ce que** le circuit électronique (5) contient un processeur assurant l'analyse des pressions et incluant des méthodes permettant le traitement des applications, et des moyens permettant d'envoyer les données mesurées à partir des capteurs et le résultat des traitements.

10. Capteur pour la mesure d'une pression et/ou d'une traction apte à être intégré dans un dispositif selon la reventication 1, ledit capteur étant à apte à être connecté à un circuit électronique (5) mesurant la variation de la résistance électrique lorsqu'une pression et/ou une traction est exercée sur ledit capteur, la pression et/ou la traction étant une fonction de la variation de la résistance, **caractérisé en ce qu'**il est constituée par un arrangement d'au moins trois types de fibres ne formant qu'une seule couche (1), des fibres piézo-résistives formant des zones piézo-résistives (2), des fibres conductrices formant des zones électriquement conductrices (3), et des fibres isolantes formant des zones électriquement isolantes (4).

11. Capteur suivant la revendication 10 **caractérisé en ce que** la couche (1) est constituée d'au moins une zone piézo-résistive (2) et d'au moins deux zones conductrices (3) isolées l'une de l'autre par des zones isolantes (4) et en contact par paires avec la zone piézo-résistive (2), chacune desdites zones (2,3,4) pouvant être constituées d'une ou plusieurs rangées de fibres.

12. Capteur suivant l'une quelconque des revendications 10 ou 11 **caractérisé en ce que** la couche (1) est constituée de plusieurs zones piézo-résistives (2), une zone conductrice (3) commune connectant une grappe de zones piézo-résistives (2) afin de diminuer le nombre de paires de zones conductrices (3).

13. Capteur suivant l'une quelconque des revendications 10 à 12 **caractérisé en ce que** le matériau piézo-résistif consiste dans un polymère conducteur intrinsèque (PCI) et/ou un métal organique et/ou dans des nanotubes de carbone.et/ou de la polyaniline et/ou du polypyrrole.

14. Capteur suivant l'une quelconque des revendications 10 à 13 **caractérisé en ce que** les fils conducteurs consistent dans des fils d'argent et/ou de nickel.

15. Procédé de fabrication d'au moins un capteur pour la mesure d'une pression et/ou d'une traction apte à être connecté à un circuit électronique (5) mesurant la variation de la résistance électrique lorsqu'une pression et/ou une traction est exercée sur ledit capteur, la pression et/ou la traction étant une fonction de la variation de la résistance, **caractérisé en ce qu'**il consiste à réaliser sur une seule couche (1) un arrangement par tissage, tricotage ou tressage d'au moins trois types de fibres, des fibres piézo-résistives, des fibres conductrices et des fibres isolantes, afin de former une couche textile comportant au moins une zone piézo-résistive (2), au moins deux zones électriquement conductrices (3), et au moins une zone électriquement isolante (4).

## Patentansprüche

1. Messvorrichtung des Drucks und / oder des Zugs, der an unterschiedlichen Punkten eines weichen, faltbaren und / oder dehnbaren textilen Materials ausgeübt wird, das geeignet ist, als Bekleidung, Verkleidung oder Ähnliches verwendet zu werden, **dadurch gekennzeichnet, dass** sie wenigstens einen Teil eines Sensors umfasst, der ausgehend von einer einzigen Schicht (1) erhalten wird, die durch eine Anordnung von wenigstens drei Fasertypen - piezoresistive Fasertypen, die piezoresistive Bereiche (2) bilden, leitender Faser, die elektrisch leitende Bereiche (3) bilden, und isolierende Fasern, die elektrisch isolierende Bereiche (4) bilden, und andererseits einem elektronischen Schaltkreis (5), der geeignet ist, die Variation des elektrischen Widerstandes der piezoresistiven Bereiche (2), die einem oder mehreren Kräften unterliegen, zu messen, gebildet ist.

2. Messvorrichtung gemäß Anspruch 1, **dadurch gekennzeichnet, dass** die Schicht (1) aus wenigstens einem piezoresistiven Bereich (2) und wenigstens zwei leitenden Bereichen (3), die voneinander durch isolierende Zonen (4) isoliert und paarweise mit dem piezoresistiven Bereich (2) in Kontakt sind, gebildet ist, wobei jeder der genannten Bereiche (2, 3, 4) aus einer oder mehreren Faserreihen gebildet sein kann.

3. Vorrichtung gemäß Anspruch 1 oder 2, **dadurch gekennzeichnet, dass** die Schicht (1) aus mehreren piezoresistiven Bereichen (2), einem gemeinsamen leitenden Bereich (3), der eine Traube von piezoresistiven Bereichen (2) anschließt, gebildet ist, um die Anzahl von paarweisen leitenden Bereichen (3) zu verringern.

4. Vorrichtung gemäß Anspruch 1 bis 3, **dadurch gekennzeichnet, dass** die Schicht (1), die aus den isolierenden (4), piezoresistiven (2) und leitenden (3) Bereichen gebildet ist, ausgehend von gestrickten, gewebten, nicht gewebten oder geflochtenen textilen Fasern erhalten wird.

5. Vorrichtung gemäß Anspruch 1 bis 4, **dadurch gekennzeichnet, dass** das piezoresistive Material aus einem intrinsisch leitenden Polymer (PCI) und / oder einem organischen Metall und / oder Kohlenstoffnanoröhren und / oder Polyanilin und / oder Polypyrrol besteht.

6. Vorrichtung gemäß Anspruch 1 bis 5, **dadurch gekennzeichnet, dass** die leitenden Drähte aus Silberdrähten und / oder Nickeldrähten bestehen.

7. Vorrichtung gemäß Anspruch 1 bis 6, **dadurch gekennzeichnet, dass** die leitenden, isolierenden und piezoresistiven Faserreihen ausgehend von Reihen der Schussrichtung oder Reihen der Kettrichtung des Stoffs erhalten werden, wobei die Bereiche (2, 3, 4) aus einer oder mehreren Faserreihen gebildet sein können.

8. Vorrichtung gemäß Anspruch 1 bis 7, **dadurch gekennzeichnet, dass** der elektronische Schaltkreis (5) Messmittel einer Variation des elektrischen Widerstandes ausgehend vom Abtasten der Traube der Sensoren umfasst, wobei das Abtasten ausgehend von der sequentiellen Auswahl einer der Elektroden erhalten wird, die das Paar leitender Bereiche bildet, wobei das Lesen der Variation des Widerstandes des Sensors ausgehend von einem analogen / digitalen Wandler (9) erhalten wird.

9. Vorrichtung gemäß Anspruch 8, **dadurch gekennzeichnet, dass** der elektronische Schaltkreis (5) einen Prozessor, der die Analyse der Drücke gewährleistet und Methoden beinhaltet, die die Verarbeitung der Anwendungen zulassen, sowie Mittel, die den Versand der Daten, die ausgehend von den Sensoren gemessen wurden, und das Ergebnis der Verarbeitungen enthält.

10. Sensor für die Messung eines Drucks und / oder eines Zugs, der geeignet ist, in eine Vorrichtung gemäß Anspruch 1 integriert zu werden, wobei der genannte Sensor geeignet ist, an einen elektronischen Schaltkreis (5) angeschlossen zu werden, der die Variation des elektrischen Schaltkreises misst, wenn ein Druck und / oder ein Zug auf den genannten Sensor ausgeübt wird, wobei der Druck und / oder der Zug eine Funktion der Variation des Widerstandes ist, **dadurch gekennzeichnet, dass** er durch eine Anordnung von wenigstens drei Fasertypen gebildet ist, die nur eine einzige Schicht (1) bilden, wobei die piezoresistiven Fasern piezoresistive Bereiche (2), die leitenden Fasern elektrisch leitende Bereiche (3) und die isolierenden Fasern elektrisch isolierende Bereiche (4) bilden.

11. Sensor gemäß Anspruch 10, **dadurch gekennzeichnet, dass** die Schicht (1) aus wenigstens einem piezoresistiven Bereich (2) und wenigstens zwei leitenden Bereichen (3), die voneinander durch isolierende Bereiche (4) isoliert und paarweise mit dem piezoresistiven Bereich (2) in Kontakt sind, gebildet ist, wobei jeder der genannten Bereiche (2, 3, 4) aus einer oder mehreren Faserreihen gebildet sein kann.

12. Sensor gemäß Anspruch 10 der 11, **dadurch gekennzeichnet, dass** die Schicht (1) aus mehreren piezoresistiven Bereichen (2) gebildet ist, wobei ein gemeinsamer leitender Bereich (3) eine Traube von piezoresistiven Bereichen (2) anschließt, um die Anzahl von leitenden Bereichspaaren (3) zu verringern.

13. Sensor gemäß Anspruch 10 bis 12, **dadurch gekennzeichnet, dass** das piezoresistive Material aus einem intrinsisch leitenden Polymer (PCI) und / oder einem organischen Metall und / oder aus Kohlenstoffnanoröhren und / oder Polyaninilin und / oder Polypyrrol besteht.

14. Sensor gemäß Anspruch 10 bis 13, **dadurch gekennzeichnet, dass** die leitenden Drähte aus Silberdrähten und / oder Nickeldrähten bestehen.

15. Herstellungsverfahren wenigstens eines Sensors für die Messung eines Drucks und / oder eines Zugs, der geeignet ist, an einen elektronischen Schaltkreis (5) angeschlossen zu werden, der die Variation des elektrischen Widerstandes misst, wenn ein Druck und / oder ein Zug auf den genannten Sensor ausgeübt wird, wobei der Druck und / oder der Zug eine Funktion der Variation des Widerstandes ist, **dadurch gekennzeichnet, dass** es in der Realisierung einer Anordnung auf einer einziger Schicht (1) durch Weben, Stricken oder Flechten wenigstens von drei Fasertypen - piezoresistiven Fasern, leitenden Fasern und isolierenden Fasern - besteht, damit eine textile Schicht geformt wird, die wenigstens einen piezoresistiven Bereich (2), wenigstens zwei elektrisch leitende Bereiche (3) und wenigstens einen elektrisch isolierenden Bereich (4) umfasst.

## Claims

1. A device for measuring the pressure and/or tension exerted at different points of a flexible, foldable and/or extendable textile material, which can be used as clothing, facing or for other similar uses, **characterized in that** it consists of, on the one hand, at least one sensor obtained from a single layer (1) consisting of an arrangement of at least three types of fibres - piezoresistive fibres forming piezoresistive areas (2), conductive fibres forming electrically conductive areas (3) and insulating fibres forming electrically insulated areas (4), and on the other hand, an electronic circuit (5) capable of measuring the change in the electrical resistance of the piezoresistive areas (2) subject to one or more forces.

2. A device according to claim 1, **characterized in that** the layer (1) is made up of at least one piezoresistive area (2) and at least two conductive areas (3) insulated from each other by insulating areas (4) and in contact, in pairs, with the piezoresistive area (2), with each of the said areas (2, 3, 4) possibly being made up of one or more rows of fibres.

3. A device according to any one of the claims 1 or 2, **characterized in that** the layer (1) consists of several piezoresistive areas (2) and a common conductive area (3) connecting a cluster of piezoresistive areas (2) in order to reduce the number of pairs of conductive areas (3).

4. A device according to any one of the claims 1 to 3, **characterized in that** the layer (1), consisting of insulating (4), piezoresistive (2) and conductive (3) areas, is obtained from knitted, woven, non-woven or braided textile fibres.

5. A device according to any one of the claims 1 to 4, **characterized in that** the piezoresistive material consists of an intrinsically conducting polymer (ICP) and/or an organic metal and/or carbon nanotubes and/or polyaniline and/or polypyrrole.

6. A device according to any one of the claims 1 to 5, **characterized in that** the conducting wires consist of silver and/or nickel wires.

7. A device according to any one of the claims 1 to 6, **characterized in that** the rows of conductive fibres, insulating fibres and piezoresistive fibres are obtained from rows in the weft direction or rows in the warp direction of the fabric, with the areas (2, 3, 4) possibly being made of one or more rows of fibres.

8. A device according to any one of the claims 1 to 7, **characterized in that** the electronic circuit (5) comprises means for measuring variations in the electrical resistance via scanning the cluster of sensors, with the scanning being obtained via sequentially selecting one of the electrodes forming the pair of conductive areas, and the reading of the sensor resistance variation being obtained from an analoguedigital converter (9).

9. A device according to claim 8, **characterized in that** the electronic circuit (5) contains a processor that provides the pressure analysis and which includes methods for processing the applications, and means for sending the data measured from the sensors and the results of the processing operations.

10. A sensor for measuring pressure and/or tension, which can be integrated in a device according to the claim 1, the said sensor being capable of being connected to an electronic circuit (5) measuring the variation in electrical resistance when the pressure and/or tension is exerted on the said sensor, with the pressure and/or tension being a function of the resistance variation, **characterized in that** it is made up of an arrangement of at least three types of fibres that form a single layer (1), the piezoresistive fibres forming piezoresistive areas (2), the conductive fibres forming electrically conductive areas (3) and the insulating fibres forming electrically insulating areas (4).

11. A sensor according to claim 10, **characterized in that** the layer (1) comprises at least one piezoresistive area (2) and at least two conductive areas (3) insulated from each other by insulating areas (4) and in contact, in pairs, with the piezoresistive area (2), with each of the said areas (2, 3, 4) possibly being constituted of one or more rows of fibres.

12. A sensor according to any one of the claims 10 or 11, **characterized in that** the layer (1) consists of several piezoresistive areas (2), and a common conductive area (3) connecting a cluster of piezoresistive areas (2) in order to reduce the number of pairs of conductive areas (3).

13. A sensor according to any one of the claims 10 to 13, **characterized in that** the piezoresistive material consists of an intrinsically conducting polymer (ICP) and/or an organic metal and/or carbon nanotubes and/or polyaniline and/or polypyrrole.

14. A sensor according to any one of the claims 10 to 13, **characterized in that** the conducting wires consist of silver and/or nickel wires.

15. A method for manufacturing at least one sensor for measuring pressure and/or tension, capable of being connected to an electronic circuit (5) measuring the variation in electrical resistance when pressure and/or tension is exerted on the said sensor, with the pressure and/or tension being a function of the resistance variation, **characterized in that** it consists of creating an arrangement on one layer (1) by weaving, knitting or braiding at least three types of fibres - piezoresistive fibres, conductive fibres and insulating fibres - in order to form a textile layer that comprises at least one piezoresistive area (2), at least two electrically conductive areas (3), and at least one electrically insulated area (4).
